Europäisches Patentamt

European Patent Office

Office européen des brevets

(11) Veröffentlichungsnummer: **0 393 344**
**A1**

## EUROPÄISCHE PATENTANMELDUNG

(21) Anmeldenummer: **90104604.5**

(22) Anmeldetag: **12.03.90**

(51) Int. Cl.⁵: **H01J 37/34, C23C 14/34, H01L 21/00**

(30) Priorität: **20.04.89 CH 1505/89**

(43) Veröffentlichungstag der Anmeldung:
**24.10.90 Patentblatt 90/43**

(84) Benannte Vertragsstaaten:
**AT BE CH DE ES FR GB IT LI LU NL SE**

(71) Anmelder: **BALZERS AKTIENGESELLSCHAFT**

**FL-9496 Balzers(LI)**

(72) Erfinder: **Wegmann, Urs**
**Saschela**
**CH-9479 Oberschan(CH)**
Erfinder: **Haag, Walter**
**Buchenweg 2**
**CH-9472 Grabs(CH)**

(74) Vertreter: **Troesch, Hans Alfred, Dr. Ing. et al**
**Walchestrasse 19**
**CH-8035 Zürich(CH)**

(54) **Haltevorrichtung für Targets von Zerstäubungsquellen und Verfahren zum Festhalten eines Targets in einer Halterung.**

(57) Die Haltevorrichtung (1) für Targets (3) von Zerstäubungsquellen ist mit einer Auflage (9) für das Target und Haltemitteln (7) am Target versehen. Die Auflage (9) weist eine der Targetrückseite (5) gegenüberliegende flexible Wand (12) auf. Diese dient dazu, mittels eines Fluidums das Target (3) zu dessen betriebsmässigem Positionieren an die Haltemittel (7) zu pressen und den benötigten Wärmeaustausch herzustellen. Die Auflage (9) ist als von Kühlmittel durchflossene Kühlunterlage ausgebildet. Sie hat eine flexible, elastisch deformierbare Wand (12) zum Festklemmen des Targets (3). In drucklosem Zustand der Auflage (9) ist deren Abstand von den Targethaltemitteln (7) derart, dass ein Target (3) in die Haltevorrichtung einschiebbar wird. Diese einfache Haltevorrichtung ermöglicht ein schnelles und sicheres Auswechseln von Targets und erlaubt deren optimale Belastung durch optimale Kühlung im Betrieb.

Fig. 1

EP 0 393 344 A1

Die vorliegende Erfindung betrifft eine Haltevorrichtung für Targets von Zerstäubungsquellen mit einer Auflage für das Target und Haltemitteln am Target und ein Verfahren zum Festhalten eines Targets in einer Halterung.

Targets werden heute in der Regel durch mehrfaches Verschrauben befestigt. Das Lösen und richtige Festziehen von vielen Schrauben, vor allem bei langen Targets, ist aufwendig. Da Targetmaterialien Verbrauchsmaterialien sind, welche öfters gewechselt werden müssen, spielt der Zeitaufwand zu deren Befestigung eine wesentliche Rolle.

Die vorliegende Erfindung bezweckt die Schaffung einer einfachen Haltevorrichtung, welche ein schnelles und sicheres Auswechseln von Targets ermöglicht und deren optimale Belastung durch optimale Kühlung im Betrieb zu erreichen versucht.

Eine derartige Haltevorrichtung zeichnet sich gemäss der vorliegenden Erfindung durch den Inhalt eines der Ansprüche aus.

Die Erfindung wird anschliessend beispielsweise anhand einer Zeichnung erläutert.

Es zeigt rein schematisch:

Fig. 1 einen Ausschnitt aus einer im Schnitt dargestellten Haltevorrichtung mit eingelegtem Target, in gelöster Lage zum Auswechseln des Target,

Fig. 2 den Ausschnitt nach Fig. 1 mit dem Target in angehobener, eingespannter Lage,

Fig. 3 einen Schnitt gemäss Schnittlinie III-III der Fig. 2.

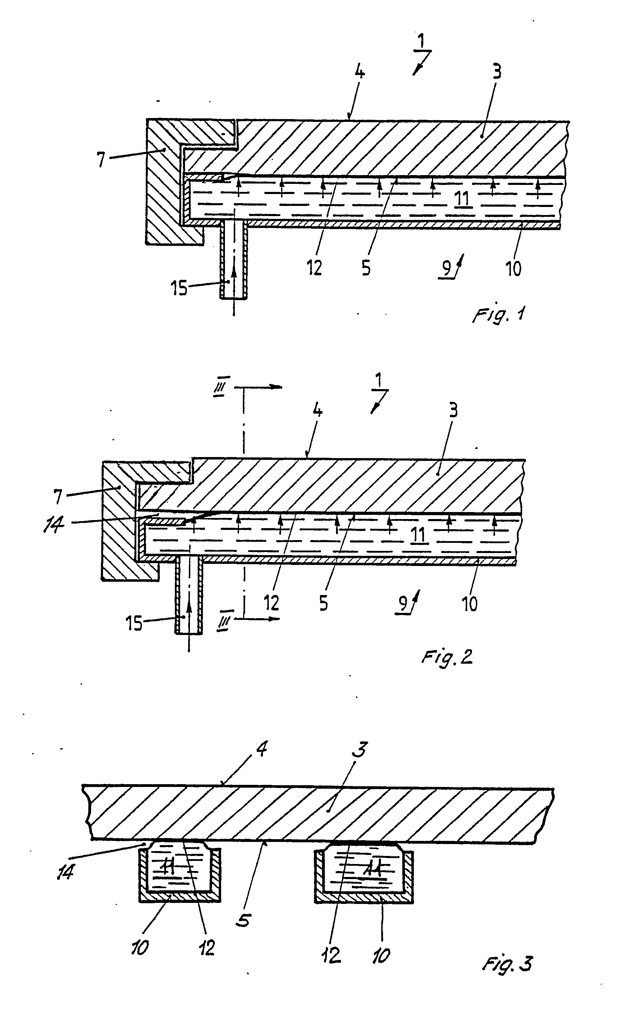

Die dargestellte Targethalterung 1 zeigt ein Target 3 mit einer Targetvorderseite 4 und einer Targetrückseite 5. Das Target 3 wird auf seiner Vorderseite 4 mittels eines Halterahmens 7 festgehalten. Das Target 3 ruht auf einer Kühlunterlage 9, welche von einem Kühlmittel, insbesondere Wasser, durchflossen ist. Die Kühlunterlage 9 weist eine starre Rückwand 10 auf. Sie wird durch vier Seitenwände und eine flexible Vorderwand 12 begrenzt und bildet einen von einem Fluidum durchflossenen Hohlraum 11. Die Kühlunterlage 9 ist mit dem Halterahmen 7, wie Fig. 1 zeigt, starr verbunden, wobei ein Kühlmittelanschluss 15 der Zuführung des Kühlmittels dient.

Targets müssen nicht ausschliesslich flache Platten sein. Diese können verschiedene Profile aufweisen und rechteckige, runde oder beliebige den Prozessbedürfnissen angepasste Formen haben, z.B. plane, gewölbte, konische, abgeflachte, zylindrische usw.

Bei auf Trägerrückplatten gebondeten Targets können beliebige Haltevorrichtungen verwendet werden. Das Target 3 kann auch eine U-förmige Nut am Umfang aufweisen, in welche der obere Schenkel des Halterahmens 7 zwecks Halterung eingeschoben wird.

Im Ruhezustand gemäss Fig. 2 ist der Abstand 14 zwischen der flexiblen Vorderwand 12, der Kühlunterlage 9 und dem zum Aufliegen auf dem Target 3 vorgesehenen Halterahmen 7 derart, dass ein Target mühelos eingeschoben werden kann, z. B. einige Zehntel mm. Nach dessen Einschieben und nach dem Einschalten der Kühlflüssigkeit wird im Hohlraum 11 ein Druck von beispielsweise 2 bar herrschen, welcher die flexible Vorderwand 12 gegen die Targetrückseite 5 drückt, das Target 3 hebt und dieses mit den benötigten Festhaltekräften gegen den Halterahmen 7 presst, wodurch auch ein optimaler Wärmeaustausch erreicht wird. Diese angehobene Lage der Targetvorderseite 4 ist in den Figuren 2 und 3 ersichtlich. Fig. 3 zeigt zudem die Möglichkeit, mehrere Kühlkanäle vorzusehen. Die ungekühlten Targetteile können dabei durch ungekühlte Träger gestützt sein (nicht dargestellt).

Dieses Vorgehen hat den grossen Vorteil, dass durch Hilfe einer derartigen, durch ein Fluidum belasteten flexiblen Vorderwand 12 eine gleichmässige Flächenpressung zwischen Target und Halterahmen 7 sichergestellt wird, und dass das Auswechseln des Targets ohne Werkzeuge durch einfaches Ein- bzw. Ausschalten des Kühlmediums in kürzester Zeit sicher und einfach erfolgen kann.

Es ist grundsätzlich möglich, die Kühlunterlage 9 so zu unterteilen, dass nur die dem Halterahmen 7 entsprechenden Auflageflächen des Targets 3 mit den hohen Drücken von beispielsweise einigen bar beaufschlagt werden, während auf die vom Halterahmen 7 nicht berührten Teile des Targets 3 wesentlich geringere Drücke wirken, welche aber genügen, den gewünschten Wärmedurchgang zwischen Target und Kühlflüssigkeit sicherzustellen. Als flexible Wand kann eine Membran dienen, welche beispielsweise als Metallfolie ausgebildet ist. Diese Wand ist vorzugsweise elastisch deformierbar, so dass sie bei den angegebenen Drucken mühelos grossflächig zum Anliegen auf der Targetrückseite 5 kommt. Es ist aber auch möglich, die Wand so auszubilden, dass sie nur in vorbestimmten Teilbereichen das Target bedeckt.

Alle in der Beschreibung und/oder den Figuren dargestellten Einzelteile und Einzelmerkmale sowie deren Permutationen, Kombinationen und Variationen sind erfinderisch, und zwar für n Einzelteile und Einzelmerkmale mit den Werten n = 1 bis n →φ.

**Ansprüche**

1. Haltevorrichtung (1) für Targets (3) von Zerstäubungsquellen mit einer Auflage (9) für das Target und Haltemitteln (7) am Target, dadurch gekennzeichnet, dass die Auflage (9) mindestens eine der Targetrückseite (5) gegenüberliegende flexible Wand (12) aufweist, um mittels eines Fluidums (11) das Target (3) zu dessen betriebsmässiger Positionierung an die Haltemittel (7) zu pressen und den benötigten Wärmeaustausch herzustellen.

2. Haltevorrichtung, vorzugsweise nach mindestens einem der Ansprüche, dadurch gekennzeichnet, dass die Auflage (9) als von Kühlmittel durchflossene Kühlunterlage ausgebildet ist und eine flexible Wand (12) zum Festklemmen des Targets (3) aufweist.

3. Haltevorrichtung, vorzugsweise nach mindestens einem der Ansprüche, dadurch gekennzeichnet, dass die flexible Wand (12) elastisch deformierbar ist.

4. Haltevorrichtung, vorzugsweise nach mindestens einem der Ansprüche, dadurch gekennzeichnet, dass in drucklosem Zustand der Auflage (9) deren Abstand von den Targethaltemitteln (7) derart ist, dass ein Target (3) in die Haltevorrichtung einschiebbar wird.

5. Haltevorrichtung, vorzugsweise nach mindestens einem der Ansprüche, dadurch gekennzeichnet, dass die Auflage (9) und die Haltemittel (7) starr miteinander verbunden sind.

6. Haltevorrichtung, vorzugsweise nach mindestens einem der Ansprüche, dadurch gekennzeichnet, dass die Haltemittel (7) zum rahmenförmigen Uebergreifen oder Eingreifen am Target (3) ausgebildet sind.

7. Haltevorrichtung, vorzugsweise nach mindestens einem der Ansprüche, dadurch gekennzeichnet, dass die flexible Wand (12) als Membrane, z.B. als Metallfolie, ausgebildet ist.

8. Haltevorrichtung, vorzugsweise nach mindestens einem der Ansprüche, dadurch gekennzeichnet, dass die flexible Wand (12) das Target grossflächig überdeckt oder nur in bestimmten Teilbereichen bedeckt.

9. Haltevorrichtung, vorzugsweise nach mindestens einem der Ansprüche, dadurch gekennzeichnet, dass mehrere Kühlkanäle (10) vorgesehen sind, welche je eine Membran (12) aufweisen.

10. Verfahren zum Festhalten eines Targets in einer Halterung, vorzugsweise nach mindestens einem der Ansprüche, dadurch gekennzeichnet, dass man das Target ausschliesslich mittels eines Fluidums in der Halterung in Betriebslage einklemmt.

Fig. 1

Fig. 2

Fig. 3

Europäisches Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | DE-A-3603646 (BALZERS HOCHVAKUUM GMBH) <br> * Zusammenfassung; Figuren * <br> --- | 1, 5, 6, 10 | H01J37/34 <br> C23C14/34 <br> H01L21/00 |
| A | IBM TECHNICAL DISCLOSURE BULLETIN. <br> vol. 12, no. 10, März 1970, NEW YORK US <br> Seite 1713 F.L. Kurtz: <br> "Holders for irregularly formed integrated circuits." <br> --- | | |
| A | IBM TECHNICAL DISCLOSURE BULLETIN. <br> vol. 13, no. 5, Oktober 1970, NEW YORK US <br> Seiten 1304 - 1305; W:A: Klein: <br> "Mask support and clamp structure." <br> ----- | | |

RECHERCHIERTE
SACHGEBIETE (Int. Cl.5 )

H01J
H01L
C23C

Der vorliegende Recherchenbericht wurde für alle Patentansprüche erstellt

| Recherchenort | Abschlußdatum der Recherche | Prüfer |
|---|---|---|
| DEN HAAG | 26 JULI 1990 | SCHAUB G.G. |

EPO FORM 1503 03.82 (P0403)